# EUROPEAN PATENT APPLICATION

(11) **EP 2 395 552 A2**
(43) Date of publication of application: **14.12.2011**
(21) Application number: 11004700.8
(22) Date of filing: 09.06.2011
(51) Int. Cl.: H01L 31/0216, H01L 31/0236

(54) **Anti-reflection barrier layer in photovoltaic device**

(30) Priority: 11.06.2010 IN DE13602010
(71) Applicant: Moser Baer India Ltd., New Dehli 110020 (IN)
(72) Inventor: Erven, Adrianus, Johannes, Maria van, New Dehli 110020 (IN)
(74) Representative: Beck & Rössig European Patent Attorneys

(57) **Abstract**

A photovoltaic device (**100, 200**) for photoelectric conversion of incident solar light is provided. The photoelectric device (**100, 200**) includes a transparent substrate (**102, 202**) having a substantially flat surface, and a textured layer (**104, 204**) on the flat surface of the transparent substrate (**102, 202**) to form light trapping structures. Thereafter, the photoelectric device (**100, 200**) includes a barrier layer (**106, 246**) on the textured layer (**104, 204**). The barrier layer (**106, 206**) is impermeable to one or more fluids released by the textured layer (**104, 204**). Further, the photoelectric device (**100, 200**) includes one or more semiconductor layers (**110, 112, 114, 210, 212, 214, 216, 218**) on the barrier layer (**106, 206**). The barrier layer (**106, 206**) prevents contamination of the one or more semiconductor layers (**110, 112, 114, 210, 212, 214, 216, 218**) from the one or more fluids. Finally, the photoelectric device (**100, 200**) includes a cover substrate (**116**) on the one or more semiconductor layers (**110, 112, 114, 210, 212, 214, 216, 218**).

## Description

### INCORPORATION BY REFERENCE OF PRIORITY DOCUMENT

This application is based on, and claims the benefit of priority from Indian Patent Application No. 1360/DEL/2010 entitled "ANTI-REFLECTION BARRIER LAYER IN PHOTOVOLTAIC DEVICE" which was filed on June 11, 2010.

### FIELD OF INVENTION

The invention disclosed herein relates, in general, to photovoltaic devices such as solar cells. More specifically, the present invention relates to thin film solar cells.

### BACKGROUND

A solar cell is a device that converts solar energy into electrical energy. Solar cells include photoactive semiconductor layers of p-doped semiconductor, i-doped semiconductor, and n-doped semiconductor. These photoactive semiconductor layers absorb solar light and generate electron-hole pairs which are drawn as current in the external circuit.

Using substrates or superstrates that have an nano-texture can have a significant effect on the efficiency of the thin film solar cells because this nano-texture enhances trapping of light by the solar cell. A nano-structure can be deposited on substrates or superstrates by use of lacquers and sol-gel materials. However, the problem with these materials is that they tend to contaminate the semiconductor layers of solar cells by solvents released by these materials during manufacturing of solar cell. Thus, the contamination of the semiconductor layers by nano-structure of lacquers and sol-gel materials decreases the efficiency of the solar cell. Another problem with the use of lacquers and sol-gel materials is that their adhesion with the Transparent Conductive Oxide (TCO) layer can be less than the adhesion between for example, substrate or superstrate and the TCO layer. This makes the solar cell unstable and reduces the life of the solar cell.

The above drawbacks make the use of nano-texture on substrates or superstrates of the solar cell difficult and impractical. Thus, there is a need for a solar cell which can effectively utilize the nano-texture to increase the efficiency of the solar cell by mitigating the above drawbacks.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.

FIG. 1 is a diagrammatic illustration of various components of an exemplary photovoltaic device according to an embodiment of the present invention;

FIG. 2 is a diagrammatic illustration of various components of an exemplary photovoltaic device according to another embodiment of the present invention;

FIG. 3 is a flow chart describing an exemplary method of manufacturing a photovoltaic device, in accordance with an embodiment of the present invention; and

FIG. 4 is a flow chart describing a method manufacturing a photovoltaic device, in accordance with another embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The instant exemplary embodiments provide a photovoltaic device for photoelectric conversion of incident solar light.

Some embodiments of the present invention provide a method for manufacturing a photovoltaic device.

The present invention provides photovoltaic devices for photovoltaic conversion of solar light. According to the invention, the photovoltaic devices have a stack of layers including a transparent substrate, a textured layer of a viscous curable material, a harrier layer, a layer of Transparent Conductive Oxide (TCO), multiple semiconductor layers and a cover substrate. The barrier layer facilitates adhesion between the textured layer of the viscous curable material and the first layer of TCO. Further, the barrier layer is also impermeable to contaminants that originate from the transparent substrate and the viscous curable material during manufacturing of the photovoltaic device or during actual usage of the photovoltaic device, thereby preventing any detrimental effect of the contaminants on other deposited layers.

In some embodiments, a photovoltaic device for photoelectric conversion of incident solar light is provided. The photovoltaic device includes a transparent substrate having a substantially flat surface. Further, the photovoltaic device includes a textured layer deposited or the flat surface of the transparent substrate to form a light trapping structure. The photovoltaic device also includes a barrier layer deposited on the textured layer. The barrier layer is impermeable to one or more fluids released by the textured layer. Further, the photovoltaic device includes one or more semiconductor layers deposited on the barrier layer. The barrier layer prevents contamination of the one or more semiconductor layers from the one or more fluids. Finally, the photovoltaic device includes a cover substrate.

In some embodiments, a photovoltaic device for photoelectric conversion of incident solar light is provided. The photovoltaic device includes a transparent substrate having a substantially flat surface. Further, the photovoltaic device includes a textured layer deposited on the flat surface of the transparent substrate to form a light trapping structure. The photovoltaic device also includes a barrier layer deposited on the textured layer. The barrier layer is impermeable to one or more fluids released by the textured layer. Also, the photoelectric device includes a transparent conductive oxide layer deposited on the barrier layer. Further, the photovoltaic device includes one or more semiconductor layers deposited on the transparent conductive oxide layer. The barrier layer prevents contamination of the one or more semiconductor layers from the one or more fluids. Finally, the photovoltaic device includes a cover substrate.

### DESCRIPTION OF THE EXEMPLARY EMBODIMENTS

Before describing the present invention in detail, it should be observed that the present invention utilizes a combination of method steps and apparatus components related to a method of manufacturing a photovoltaic device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

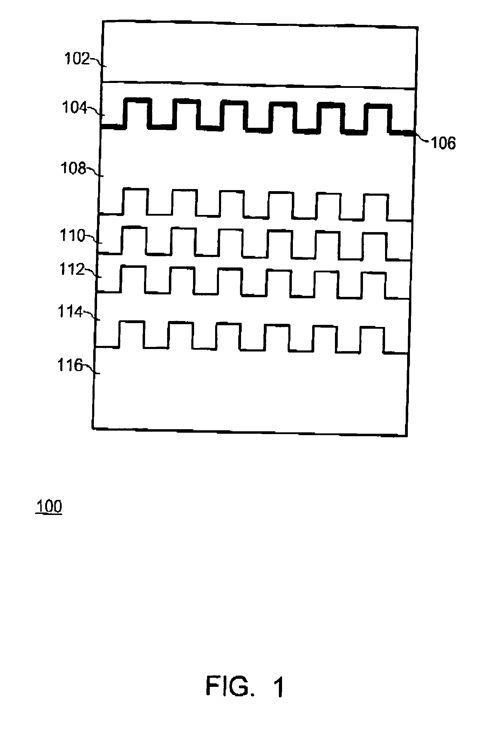

Referring now to the drawings, there is shown in FIG. 1, a diagrammatic illustration of various components of an exemplary photovoltaic device 100 according to an embodiment of the present invention. Examples of the photovoltaic device 100 include, but are not limited to, a thin film solar cell, an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like. The photovoltaic device **100** brings about photoelectric conversion of incident solar light to generate electricity. Layers of semiconductor material, present in the photovoltaic device **100,** are responsible for generation of this electricity. Photons present in the incident solar light are received by the layers of semiconductor material, resulting in subsequent generation of excitons, i.e., bound electron-hole pairs. These bound electron-hole pairs dissociate into free electrons and holes within the layers of semiconductor material. The free electrons and holes act as the charge carriers that are responsible for generating electricity.

The photovoltaic device **100** is shown to include a stack of a substrate **102,** a layer 104 of a viscous curable material, a barrier layer **106,** a layer **108** of TCO, multiple semiconductor layers **110, 112, 114** and a cover substrate **116.**

The substrate **102** provides strength to the photovoltaic device **100** and is used as a starting point for deposition of other layers that constitute the photovoltaic device 100. An example of a material of the substrate **102** includes, but is not limited to, glass and transparent plastics. In some exemplary embodiments, during real life applications, the photovoltaic device **100** is placed in a way that the substrate **102** is facing the sun and all the sun light falling on the photovoltaic device **100** is incident on the substrate **102.** In these embodiments, the substrate **102** is made of a transparent material so that it allows maximum light to pass through itself and reach the subsequent layers. The substrate **102** includes a flat surface on which other subsequent layers can be deposited.

Moving on to the layer **104** of the viscous curable material. The layer 104 of the viscous curable material may also be referred to as a textured layer **104** of viscous curable material in the subsequent description for ease in understanding of the various embodiments of the invention. The textured layer **104** of the viscous curable material is deposited over the substrate **102.** First, a viscous curable material is deposited over the substrate **102.** The viscous curable material should be able to retain any nano-texture embossed on it when it is cured by using mediums such as heat or light to form a textured layer **104** of the viscous curable material over the substrate **102.** The viscous curable material can include, but is not limited to, an ultra-violet curable material, a photo-polymer lacquer, an acrylate, and silica or silica-titania based sol-gel materials.

In some embodiments, the viscous curable material is pre-cured by using light and/or heat prior to depositing the layer **104** of the viscous curable material on the flat surface of the substrate **102.** Pre-curing of the viscous curable material is performed in order to minimize the out-gassing of fluids or solvents from the viscous curable material during later stages of manufacturing of the photovoltaic device **100** or during actual usage of the photovoltaic device 100. These fluids or solvents coming out of the viscous curable material have a tendency to contaminate subsequent layers of the photovoltaic device **100** and thus, impact the overall performance of the photovoltaic device **100.**

In accordance with the present invention, the layer **104** of the viscous curable material is deposited in a manner such that a texture is formed on a surface of the layer 104 of the viscous curable material. The examples of the texture include, but are not limited to, V-shaped or U-shaped features, a ID or 2D periodic grating (rectangular or sinusoidal), a blazed grating, and random pyramids. This texture is such that it that enables and enhances light trapping capability of semiconductor layers of the photovoltaic device **100.** This texture helps in scattering and diffraction of the light and thus, enhances the light path through the photovoltaic device **100** and hence, enhances the chance of absorption of light by the semiconductor layers of the photovoltaic device **100.**

Several methods can be used to create the texture on the layer **104** of the viscous curable material that enables light trapping. In one embodiment, the texture can be created by applying a thin layer **104** of the viscous curable material, such as a photo-polymer lacquer or a sol-gel material, onto the substrate **102** and then pressing a stamper with the nano-textured surface into this layer **104.** Further, a UV curing process is applied to freeze the nano-texture on the layer **104** of the viscous curable material.

To increase light absorption in the photovoltaic device **100,** diverse textures can be created on the textured layer **104** of the viscous curable material by defining appropriate angular scattering functions and optimizing surface profiles to enhance number of absorbed photons. In an embodiment, the textured layer **104** may include a texture that is periodic or quasi-periodic in nature.

In another embodiment, the texture can be created by applying a thin layer **104** of the viscous thermally curable material, such as a photo-polymer lacquer or a sol-gel material, onto the substrate **102** and then pressing a stamper with the nano-textured surface into this layer **104.** Further, heat is applied to the layer **104** in order to freeze the nano-texture on the layer **104** of the viscous curable material.

In yet another embodiment, the texture can be created by pressing the stamper against the substrate **102** while it is being heated above its deformation (glass transition) temperature (hot-embossing), followed by a rapid cooling process. Following this, the layer **104** of the viscous curable material is deposited on the substrate **102.** In another embodiment, the texture can be created by use of injection molding technique. In this embodiment, an injection molding die is mounted on the surface of the substrate **102** and the texture is formed by injecting the viscous curable material in the injection molding die.

In some embodiments, after the layer **104** of the viscous curable material has been deposited over the substrate **102,** annealing of the layer **104** of viscous curable material is performed. The main purpose of annealing is to eliminate maximum amount of the fluids or solvents released by the viscous curable material and/or the substrate **102** before other layers can be deposited.

Moving on to the barrier layer **106.** The barrier layer **106** is deposited on the layer 104 of the viscous curable material after the layer **104** of the viscous curable material has been deposited on the transparent substrate **102.** The barrier layer **106** is impermeable to the fluids or solvents, such as volatile organic compounds like photoinitiator remains, non-reacted resins, side-reaction products or impurities, which are released by the viscous curable material during later stages of manufacturing of the photovoltaic device **100** or during actual usage of the photovoltaic device **100.** The barrier layer **106** is also impermeable to contaminants that originate from substrates like sodium. Thus, the barrier layer **106** prevents the detrimental effect of the contaminants/elements, fluids or solvents released by the viscous curable material and/or the substrate (like sodium from glass) **102** on other deposited layers, such as the first layer **108** of TCO, and semiconductor layers **110, 112** and **114** or on an encapsulant of the photovoltaic device **100.**

The use of barrier layer **106** is important because after the texture that enables light trapping has been embossed on the layer **104** of the viscous curable material, it is annealed at higher temperatures in the range of 250-300 degrees Celsius. During this process of annealing, a lot of contaminants/elements, fluids or solvents come out from the viscous curable material and/or the substrate **102.** Further, these elements, fluids or solvents have the tendency to contaminate the other deposited layers, such as semiconductor layers or the encapsulant. The barrier layer **106** prevents elements, fluids or solvents coming from the viscous curable material and/or the substrate **102** to contaminate the other deposited layers.

The barrier layer **106** can be made from a material which is optically transparent. The barrier layer **106** is kept as optically transparent to allow light to pass through itself once the light enters the photovoltaic device **100,** and thereby, facilitate generation of electricity by semiconductor layers **110, 112** and **114.** Further, the refractive index of the barrier layer **106** generally ranges between 1.4 and 2.2. In general, the refractive index of the barrier layer **106** is dependent on the refractive index of the substrate **102** and the refractive index of TCO. For example, if the reflective index of barrier layer **106** is lesser than that of the substrate 102 then no light will pass through the barrier layer **106** and will reflect back into the substrate **102.** On the other hand, for example if the reflective index of the barrier layer **106** is greater than that of the TCO, then no light will pass into the TCO. As a result, the refractive index of the barrier layer **106** should lie between the refractive index of the substrate **102** and the refractive index of TCO. For example, if the substrate **102** is glass having a refractive index of 1.5 and the refractive index of TCO is 1.9, then the refractive index of the barrier layer **106** should lie between 1.5 and 1.9. Ideally, the refractive index of the barrier layer **106** should be √(n_{substrate} x n_{TCO}), where n_{substrate} is the refractive index of the substrate **102** and n_{TCO} is the refractive index of TCO. Therefore, in above example, the refractive index of the barrier layer **106** can be √(1.5 x 1.9), i.e. 1.69.

Thickness of the barrier layer **106** can vary based on the wavelength of the light that the photovoltaic device **100** intends to trap. However, in general, the thickness of the barrier layer **106** can range between I nanometer and 150 nanometers. In cases where the layer thickness for the barrier layer **106** corresponds with a quarter of the wavelength of the light that needs to be trapped, the barrier layer **106** serves as antireflection layer as well. The materials that can be used for the barrier layer **106** include, but are not limited to, silicon oxides (SiOₓ), silicon nitrides (SiNₓ), Al₂O₃, ZnS:SiO₂ and SiON. The adhesion between the layer **104** of the viscous curable material and the first layer **108** of TCO is not substantial to provide stability to the photovoltaic device **100. The** barrier layer **106** facilitates adhesion between the layer **104** of the viscous curable material and the first layer **108** of TCO- The adhesion between the layer **104** of the viscous curable material and the first layer **108** of TCO is facilitated as the adhesion between the material selected for the barrier layer **106** and the layer **104** of the viscous curable material, as well as the adhesion between the barrier layer **106** and the first layer **108** of TCO is greater than the adhesion between the layer **104** of the viscous curable material and the first layer **108** of TCO.
Moving on to the layer **108** of TCO. The layer **108** of TCO is deposited over the barrier layer **106.** TCOs are doped metal oxides used in photovoltaic devices. Examples of TCOs include, but are not limited to, Aluminum-doped Zinc Oxide (AZO), Boron doped Zinc Oxide (BZO), Gallium doped Zinc Oxide (GZO), Fluorine doped Tin Oxide (FTO) and Indium doped Tin Oxide (ITO). TCOs have more than 80% transmittance of incident light and have conductivities higher than 10³ S/cm for efficient carrier transport The transmittance of TCOs, just as in any transparent material, is limited by light scattering at defects and grain boundaries.

Next set of layers in the stack of photovoltaic device **100** are the semiconductor layers **110, 112** and **114.** Generally, the semiconductor layers are deposited using chemical vapour deposition, sputtering, and hot wire techniques on the layer **108** of TCO. For the purpose of this description, the semiconductor layers are shown to include a layer ofp-doped semiconductor **110,** a layer of i-doped semiconductor **112,** and a layer of n-doped semiconductor **114.** However, it will be readily apparent to those skilled in the art that the photovoltaic device **100** include or exclude one or more semiconductor layers without deviating from the scope of the invention.

For the purpose of this description, the layer of p-doped semiconductor **110,** the layer of i-doped semiconductor **112,** and the layer ofn-doped semiconductor **114** are made ofa-Si:H.

In general, when glass is used as a superstrate or substrate, the semiconductor layers are deposited in a p-i-n sequence, i.e. p-doped semiconductor, i-doped semiconductor, and n-doped semiconductor. This is because the mobility of electrons in a-Si:H is nearly twice than that of holes in aSi:H, and thus the collection rate of electrons moving from the p- to n-type contact is better as compared to holes moving from p- to n-type contact. Therefore, the p-doped semiconductor layer is placed at the top where the intensity of light is more.

Following the semiconductor layers, a cover substrate **116** is deposited. The cover substrate **116** forms the back contact of the photovoltaic device **100.** In some cases, commercially available photovoltaic device **100** may have additional layers to enhance their efficiency or to improve the reliability.

The photovoltaic device **100** is structured so as to have a stack of layers including the transparent substrate **102,** the textured layer **104** deposited on the transparent substrate **102** to form a light trapping structure. Followed by the barrier layer **106** deposited on the textured layer **104** and the one or more semiconductor layers **110,112** and **114** deposited on the barrier layer **106.** Finally, the photovoltaic device **100** also includes the cover substrate **116.** All the above mentioned layers are encapsulated using an encapsulation to obtain the photovoltaic device **100.**

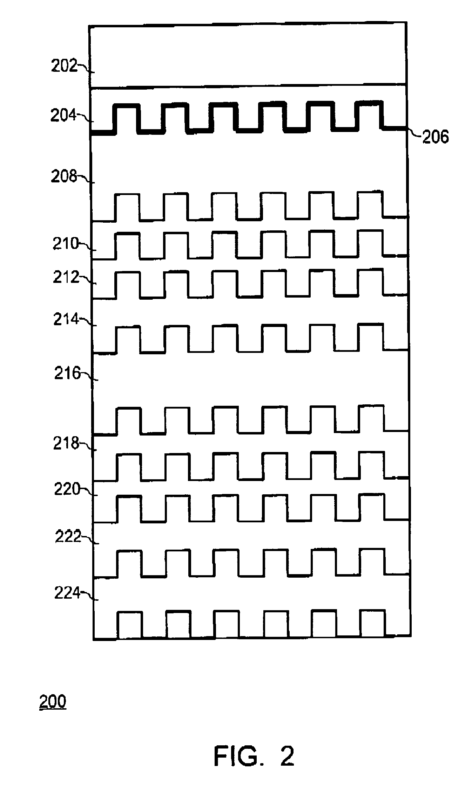

Referring now to **FIG. 2****,** there is shown a diagrammatic illustration of various components of an exemplary photovoltaic device **200** according to another embodiment of the present invention. Examples of the photovoltaic device **200** include, but are not limited to, a thir film solar cell, an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like. The photovoltaic device **200** is shown to include a stack of a substrate **202,** a layer **204** of a viscous curable material, a barrier layer **206,** a first layer **208** of TCO, multiple semiconductor layers **210, 212, 214, 216** and **218,** a second layer **220** of TCO, a layer **222** of silver, and a layer **224** of aluminum.

The substrate 202 provides strength to the photovoltaic device **200** and is used as a starting point for deposition of other layers that constitute the photovoltaic device **200.** An example of a material of the substrate **202** includes, but is not limited to, glass and transparent plastics. In some exemplary embodiments, during real life applications, the photovoltaic device **200** is placed in a way that the substrate **202** is facing the sun and all the sun light falling on the photovoltaic device **200** is incident on the substrate **202.** In these embodiments, the substrate **202** is made of a transparent material so that it allows maximum light to pass through itself and reach the subsequent layers. The substrate **202** includes a flat surface on which other subsequent layers can be deposited.

Moving on to the layer **204** of the viscous curable material. The layer **204** of the viscous curable material is deposited over the substrate **202.** The viscous curable material should be able to retain any nano-texture embossed on it when it is cured by using mediums such as hea or light. The viscous curable material can include, but is not limited to, an ultra-violet curable material, a photo-polymer lacquer, an acrylate, and silica or silica-titania based sol-gel materials.

In some embodiments, the viscous curable material is pre-cured by using light and/or heat prior to depositing the layer **204** of the viscous curable material on the flat surface of the substrate **202.** Pre-curing of the viscous curable material is performed in order to minimize the out-gassing of fluids or solvents from the viscous curable material during later stages of manufacturing of the photovoltaic device **200** or during actual usage of the photovoltaic device **200.** These fluids or solvents coming out of the viscous curable material have a tendency to contaminate subsequent layers of the photovoltaic device **200** and thus, impact the overall performance of the photovoltaic device **200.**

In accordance with the present invention, the layer **204** of the viscous curable material is deposited in a manner such that a texture is formed on a surface of the layer **204** of the viscous curable material. The examples of the texture include, but are not limited to, V-shaped or U-shaped features, a 1D or 2D periodic grating (rectangular or sinusoidal), a blazed grating, and random pyramids. This texture is such that it that enables and enhances light trapping capability of semiconductor layers of the photovoltaic device **200.** This texture helps in scattering and diffraction of the light and thus, enhances the light path through the photovoltaic device **200** and hence, enhances the chance of absorption of light by the semiconductor layers of the photovoltaic device **200.**

Several methods can be used to create the texture on the layer **204** of the viscous curable material that enables light trapping. In one embodiment, the texture can be created by applying a thin layer **204** of the viscous curable material, such as a photo-polymer lacquer or a sol-gel material, onto the substrate **202** and then pressing a stamper with the nano-textured surface into this layer **204.** Further, a UV curing process is applied to freeze the nano-texture on the layer **204** of the viscous curable material.

In another embodiment, the texture can be created by applying a thin layer **204** of the viscous thermally curable material, such as a photo-polymer lacquer or a sol-gel material, onto the substrate **202** and then pressing a stamper with the nano-textured surface into this layer **204.** Further, heat is applied to the layer **204** in order to freeze the nano-texture on the layer **204** of the viscous curable material.

In yet another embodiment, the texture can be created by pressing the stamper against the substrate **202** while it is being heated above its deformation (glass transition) temperature (hot-embossing), followed by a rapid cooling process. Following this, the layer **204** of the viscous curable material is deposited on the substrate **202.** In another embodiment, the texture can be created by use of injection molding technique. In this embodiment, an injection molding die is mounted on the surface of the substrate **202** and the texture is formed by injecting the viscous curable material in the injection molding die.

In some embodiments, after the layer **204** of the viscous curable material has been deposited over the substrate **202,** annealing of the layer **204** of viscous curable material is performed. The main purpose of annealing is to eliminate maximum amount of the fluids or solvents released by the viscous curable material and/or the substrate **202** before other layers can be deposited.

Moving on to the barrier layer **206.** The barrier layer **206** is deposited on the layer **204** of the viscous curable material after the layer **204** of the viscous curable material has been deposited on the transparent substrate **202.** The barrier layer **206** is impermeable to the fluids or solvents, such as volatile organic compounds like photoinitiator remains, non-reacted resins, side-reaction products or impurities, which are released by the viscous curable material during later stages of manufacturing of the photovoltaic device **200** or during actual usage of the photovoltaic device **200.** The barrier layer **206** is also impermeable to contaminants that originate from substrates like sodium. Thus, the barrier layer **206** prevents the detrimental effect of the contaminants/elements, fluids or solvents released by the viscous curable material and/or the substrate (like sodium from glass) **202** on other deposited layers, such as the first layer 108 o TCO, and semiconductor layers **210, 212, 214, 216** and **218** or on an encapsulant of the photovoltaic device **200.**

The use of barrier layer **206** is important because after the texture that enables light trapping has been embossed on the layer **204** of the viscous curable material, it is annealed at higher temperatures in the range of 250-300 degrees Celsius. During this process of annealing, a lot of contaminants/elements, fluids or solvents come out from the viscous curable material and/or the substrate **202.** Further, these elements, fluids or solvents have the tendency to contaminate the other deposited layers, such as semiconductor layers or the encapsulant. The barrier layer **206** prevents elements, fluids or solvents coming from the viscous curable material and/or the substrate **202** to contaminate the other deposited layers.

The barrier layer **206** can be made from a material which is optically transparent. Further, the refractive index of the barrier layer **206** generally ranges between 1.4 and 2.2. In general, the refractive index of the barrier layer **206** is dependent on the refractive index of the substrate **202** and the refractive index of TCO. Refractive index of the barrier layer **206** should lie between the refractive index of the substrate **202** and the refractive index of TCO. For example, if the substrate **202** is glass having a refractive index of 1.5 and the refractive index of TCO is 1.9, then the refractive index of the barrier layer **206** should lie between 1.5 and 1.9. Ideally, the refractive index of the barrier layer **206** should be √(n_{substrate} x n_{TCO}), where n_{substrate} is the refractive index of the substrate **202** and n_{TCO} is the refractive index of TCO. Therefore, in above example, the refractive index of the barrier layer **206** can be √(1.5 x 1.9), i.e. 1.69.

Thickness of the barrier layer **206** can vary based on the wavelength of the light that the photovoltaic device **200** intends to trap. However, in general, the thickness of the barrier layer **206** can range between 1 nanometer and 150 nanometers. In cases where the layer thickness for the barrier layer **206** corresponds with a quarter of the wavelength of the light that needs to be trapped, the barrier layer **206** serves as antireflection layer as well. The materials that can be used for the barrier layer **206** include, but are not limited to, silicon oxides (SiOₓ), silicon nitrides (SiNₓ), Al₂O₃, ZnS:SiO₂ and SiON. The adhesion between the layer **204** of the viscous curable material and the first layer **208** of TCO is not substantial to provide stability to the photovoltaic device **200.** The barrier layer **206** facilitates adhesion between the layer **204** of the viscous curable material and the first layer **208** of TCO. The adhesion between the layer **204** of the viscous curable material and the first layer **208** of TCO is facilitated as the adhesion between the material selected for the barrier layer **206** and the layer **204** of the viscous curable material, as well as the adhesion between the barrier layer **206** and the first layer **208** of TCO is greater than the adhesion between the layer **204** of the viscous curable material and the first layer **208** of TCO.

Moving on to the first layer **208** of TCO. The first layer **208** of TCO is deposited over the barrier layer **206.** TCOs are doped metal oxides used in photovoltaic devices. Examples of TCOs include, but are not limited to, Aluminum-doped Zinc Oxide (AZO), Boron doped Zinc Oxide (BZO), Gallium doped Zinc Oxide (GZO), Fluorine doped Tin Oxide (FTO) and Indium doped Tin Oxide (ITO). TCOs have more than 80% transmittance of incident light and have conductivities higher than 10³ S/cm for efficient carrier transport. The transmittance of TCOs, just as in any transparent material, is limited by light scattering at defects and grain boundaries.

Next set of layers in the stack of photovoltaic device **200** are semiconductor layers **210, 212, 214, 216,** and **218.** Generally, the semiconductor layers are deposited using chemical vapour deposition, sputtering, and hot wire techniques on the first layer **208** of TCO. For the purpose of this description, the semiconductor layers are shown to include a first layer of p-doped semiconductor **210,** a second layer of p-doped semiconductor **212,** a layer of buffer **214,** a layer of i-doped semiconductor **216,** and a layer of n-doped semiconductor **218.** However, it will be readily apparent to those skilled in the art that the photovoltaic device **200** include or exclude one or more semiconductor layers without deviating from the scope of the invention.

For the purpose of this description, the first layer of p-doped semiconductor **210** is made of µc Si:H. However, the second layer of p-doped semiconductor **212,** the layer of i-doped semiconductor **216,** and the layer of n-doped semiconductor **218** are made of a-Si:H.

In general, when glass is used as a superstrate or substrate, the semiconductor layers are deposited in a p-i-n sequence, i.e. p-doped semiconductor, i-doped semiconductor, and n-doped semiconductor. This is because the mobility of electrons in a-Si:H is nearly twice than that of holes in aSi:H, and thus the collection rate of electrons moving from the p- to n-type contact is better as compared to holes moving from p- to n-type contact. Therefore, the p-doped semiconductor layer is placed at the top where the intensity of light is more.

Following the semiconductor layers, a cover substrate is deposited. In one embodiment, the cover substrate includes the second layer **220** of TCO, the layer **222** of silver, and the layer **224** of aluminum. In other embodiments, the cover substrate can include at least one of the second layer **220** of TCO, the layer **222** of silver, and the layer **224** of the aluminum. These layers individually or in combination form the back contact of the photovoltaic device **200.** In some cases, commercially available photovoltaic device **200** may have additional layers to enhance their efficiency or to improve the reliability.

All the above mentioned layers are encapsulated using an encapsulation to obtain the photovoltaic device **200.**

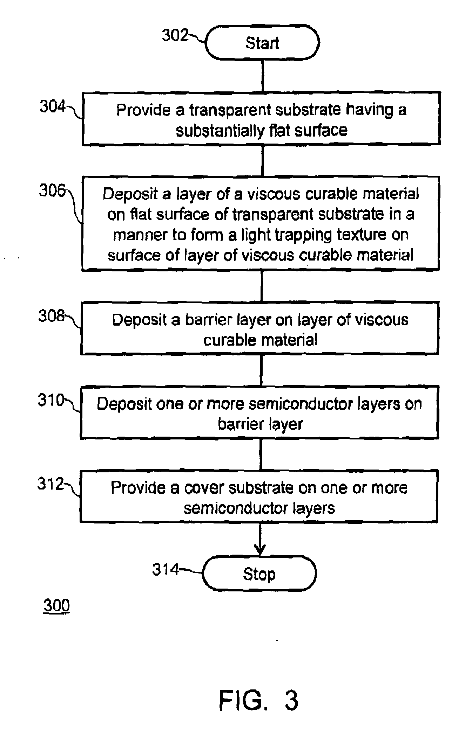

Moving on to **FIG. 3, FIG. 3** is a flow chart describing an exemplary method **300** for manufacturing the photovoltaic device **100** in accordance with an embodiment of the present invention. To describe the method **300,** reference will be made to **FIG. 1****,** although it is understood that the method **300** can be implemented to manufacture any other suitable device. Moreover, the invention is not limited to the order of in which the steps are listed in the method **300.** In addition, the method **300** can contain a greater or fewer numbers of steps than those shown in **FIG. 3****.**

The method **300** for manufacturing the photovoltaic device **100** is initiated at step **302.** At step **304,** the substrate **102** is provided. As described in conjunction with **FIG.1****,** the substrate 102 provides strength to the photovoltaic device **100** and is used as a starting point for deposition of the photovoltaic device **100.** The substrate **102** is transparent in nature and can be made of materials such as glass and transparent plastic. The substrate **102** is made of a transparent material so that it can allow maximum light to pass through itself and reach the subsequent semiconductor layers. Further, the substrate **102** includes a substantially flat surface on which other layers of the photovoltaic device **100** can be deposited.

Following this, at step **306,** the layer **104** of the viscous curable material is deposited on the flat surface of the substrate **102.** The viscous curable material can he deposited by using a brush or roller, dispensing, slot dye coating, spin-coating, spray coating or printing. The viscous curable material can include, but is not limited to, an ultra-violet curable material, a photo-polymer lacquer, an acrylate, and a sol-gel material. The layer **104** of the viscous curable material is deposited in a manner such that a texture is formed on surface of the layer **104** of the viscous curable material. This texture is such that it that enables and enhances light trapping capability of the semiconductor layers of the photovoltaic device **100.** This texture helps in scattering and diffraction of the light and thus, enhances the light path through the photovoltaic device **100** and hence, enhances the chance of absorption of light by the semiconductor layers of the photovoltaic device **100.** Various methods that can be used to form the light trapping texture on the layer **104** of the viscous curable material have been described in conjunction with **FIG. 1****.**

At step **308,** the barrier layer **106** is deposited on the layer **104** of the viscous curable material by, for example, physical vapor deposition, chemical vapor deposition, sputtering or plasma enhanced chemical vapor deposition. The barrier layer **106** is impermeable to the fluids or solvents released by the viscous curable material and the substrate 102 during later stages of manufacturing of the photovoltaic device **100** or during actual usage of the photovoltaic device 100. Thus, the barrier layer **106** prevents the detrimental effect of the fluids or solvents released by the viscous curable material and/or the substrate **102** on other deposited layers.

The barrier layer **106** can be made from a material which is optically transparent. Further, the refractive index of the barrier layer **106** ranges between 1.4 and 2.2. Generally, the thickness of the barrier layer **106** ranges between 1 nanometer and 150 nanometers. In cases where the layer thickness for the barrier layer **106** corresponds with a quarter of the wavelength of the light that needs to be trapped, the barrier layer **106** can serve as antireflection layer as wel. The materials that can be used for the barrier layer **106** include, but are not limited to, silicon oxides (SiOₓ), silicon nitrides (SiNₓ), Al₂O₃, ZnS:SiO₂ and SiON. Further, the barrier layer **106** facilitates adhesion between the layer **104** of the viscous curable material and other deposited layers, such as the layer **108** of TCO and the multiple semiconductor layers **110, 112,** and **114.**

Thereafter, at step **310,** multiple semiconductor layers are deposited on the barrier layer 106. These multiple semiconductor layers can include the layer **108** of TCO, the layer of p-doped semiconductor **110,** the layer of i-doped semiconductor **112,** and the layer of n-doped semiconductor **114.** As described in conjunction with **FIG.1****,** the semiconductor layers are deposited in a manner that they form a p-i-n structure.

Following this, at step **312,** the cover substrate **116** is provided on the multiple semiconductor layers **110, 112,** and **114.** The method **300** is terminated at step **314.**

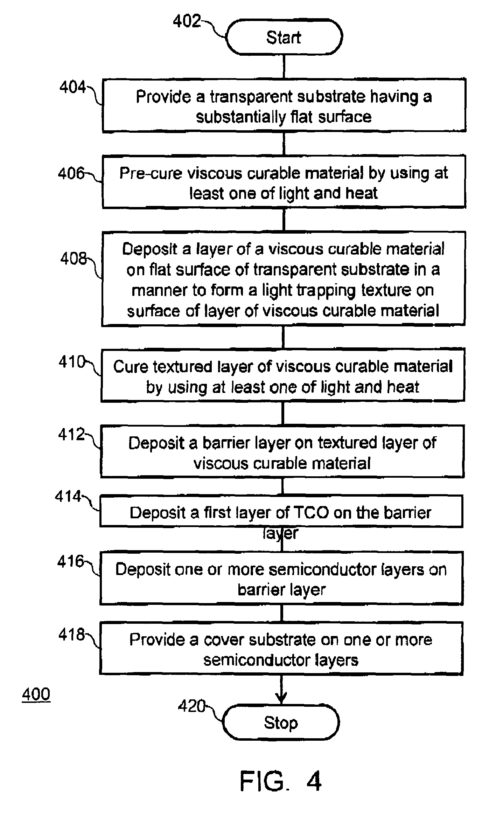

**FIG. 4** is a flow chart describing a method **400** for manufacturing the photovoltaic device **200** in accordance with another embodiment of the present invention. For the purpose of this description, the method **400** is explained for manufacturing of the photovoltaic device **200.** To describe the method **400,** reference will be made to **FIG. 2****,** although it is understood that the method **400** can also be applied, without deviating from the scope of the invention, for manufacturing any other suitable device or system. Moreover, the invention is not limited to the order of in which the steps are listed in the method **400.** In addition, the method **400** can contain a greater or fewer numbers of steps than those shown in **FIG. 4****.**

The method for manufacturing the photovoltaic device **200** is initiated at step **402.** At step **404,** the substrate **202** is provided. As described in conjunction with **FIG. 2****,** the substrate **202** provides strength to the photovoltaic device **200** and is used as a starting point for deposition of the photovoltaic device **200.** The substrate **202** is transparent in nature and can be made of materials such as glass and transparent plastics. The substrate **202** is made of a transparent material so that it can allow maximum light to pass through itself and reach the subsequent semiconductor layers. Further, the substrate **202** includes a substantially flat surface on which other layers can be deposited.

Following this, at step **406,** the viscous curable material is pre-cured by using light and/or heat. Pre-curing of the viscous curable material is performed in order to minimize the out-gassing of fluids or solvents from the viscous curable material during later stages of manufacturing of the photovoltaic device **200** or during actual usage of the photovoltaic device 200. These fluids or solvents coming out of the viscous curable material have a tendency to contaminate the subsequent layers and thus, impact the overall performance of the photovoltaic device **200.**

Following this, at step **408,** a layer **204** of pre-cured viscous curable material is deposited on the flat surface of the substrate **202.** The viscous curable material can include, but is not limited to, a ultra-violet curable material, a photo-polymer lacquer, an acrylate, and a sol-gel material. The layer **204** of the viscous curable material is deposited in a manner such that a texture is formed on a surface of the layer **204** of the viscous curable material. This texture is such that it enables and enhances light trapping capability of the semiconductor layers of the photovoltaic device **200.** This texture helps in scattering and diffraction of the light and thus, enhances the light path through the photovoltaic device **200** and hence, enhances the chance of absorption of light by the semiconductor layers of the photovoltaic device **200.**

At step **410,** the layer **204** of the viscous curable material is cured/annealed by using heat and/or light. The main purpose of annealing is to eliminate maximum amount of the fluids or solvents released by the viscous curable materials and/or the substrate 102 before other layers are deposited. The medium used for curing/annealing the viscous curable material is dependent on the viscous curable material. In case the viscous curable material is an ultra-violet curable material, then UV light is used as the curing/annealing medium. In another example, if the viscous curable material is an arcylate, then heat can be used as the curing/annealing medium. Curing/annealing of the layer **204** of the viscous curable material by heat is generally performed at higher temperatures in the range of 250-300 degree Celsius. Even after this process of curing/annealing, a lot of fluids or solvents come out from the viscous curable material and the substrate **202.** These fluids or solvents have the tendency to contaminate the other deposited layers, such as semiconductor layers. Hence, at step **412,** the barrier layer **206** is deposited on the layer **204** of the viscous curable material to prevent fluids or solvents coming from the viscous curable material and/or the substrate **202** to contaminate the other deposited layers.

The barrier layer **206** is impermeable to the fluids or solvents released by the viscous curable material and the substrate **202.** Thus, the barrier layer **206** prevents the detrimental effect of the fluids or solvents released by the viscous curable material and/or the substrate **202** on other deposited layers.

The barrier layer **206** can be made from a material which is optically transparent. further, the refractive index of the barrier layer **206** ranges between 1.4 and 2.2. Generally, the thickness of the barrier layer **206** ranges between 1 nanometer and 150 nanometers. In cases where the layer thickness for the barrier layer **206** corresponds with a quarter of the wavelength of the light that needs to be trapped, the barrier layer **206** serves as antireflection layer as well. The materials that can be used for the barrier layer **206** include, but are not limited to, silicon oxides (SiOₓ), silicon nitrides (SiNₓ), Al₂O₃, ZnS:SiO₂ and SiON. Further, the barrier layer **106** facilitates adhesion between the layer **204** of the viscous curable material and other deposited layers, such as the first layer **208** of TCO and the semiconductor layers **210, 212, 214, 216,** and **218.**

Thereafter, at step **414,** the first layer **208** of TCO is deposited on the barrier layer **206.** Thereafter, at step **416,** multiple semiconductor layers are deposited on the barrier layer **206.** These multiple semiconductor layers can include the first layer of p-doped semiconductor **210,** the second layer of p-doped semiconductor **212,** the layer of buffer **214,** the layer of i-doped semiconductor **216,** and the layer of n-doped semiconductor **218.** As described in conjunction with **FIG. 2****,** the semiconductor layers are deposited in a manner that they form a p-i-n structure.

Following this, at step **418,** the cover substrate is provided on the multiple semiconductor layers. The cover substrate includes the second layer **220** of TCO, the layer **222** of silver, and the layer **224** of aluminum. The method **400** is terminated at step **420.**

Various embodiments, as described above, provide a photovoltaic device, which has several advantages. One of the several advantages of some embodiments of this photovoltaic device is that it increases the efficiency of the photovoltaic device. Another advantage of this embodiment is that the semiconductor layers of the photovoltaic device are not contaminated by the fluids or solvents released by the viscous curable material and the substrate. Further, the barrier layer also provides better adhesion between the TCO layer and the substrate.

While the invention has been disclosed in connection with the preferred embodiments shown and described in detail, various modifications and improvements thereon will become readily apparent to those skilled in the art. Accordingly, the spirit and scope of the present invention is not to be limited by the foregoing examples, but is to be understood in the broadest sense allowable by law.

All documents referenced herein are hereby incorporated by reference.

## Claims

1. A photovoltaic device (**100, 200**) for photoelectric conversion of incident solar light, the photovoltaic device (**100, 200**) comprising a stack of at least a transparent substrate (**102, 202**) having a substantially flat surface; a textured layer (**104, 204**) provided on said substantially flat surface of said transparent substrate (**102, 202**) wherein said textured layer (**104,204**) has light trapping structures; one or more semiconductor layers (**110,112,114, 210, 212, 214, 216, 218**) provided on said textured layer (**104, 204**); and a cover substrate (**116**), **characterized in that**:
a barrier layer (**106, 206**) deposited on said textured layer (**104, 204**) prior to providing said one or more semiconductor layers (**110, 112, 114, 210, 212, 214, 216, 218**), wherein said barrier layer (**106, 206**) is impermeable to one or more fluids released by said textured layer (**104, 204**), further wherein contamination of said one or more semiconductor layers (**110, 112, 114, 210, 212, 214, 216, 218**) from said one or more fluids is prevented by said barrier layer (**106, 206**).

2. The photovoltaic device (**100, 200**) according to claim 1, wherein said textured layer (**104, 204**) is of a viscous curable material.

3. The photovoltaic device (**100, 200**) according to claim 1, wherein said barrier layer (**106, 206**) is optimally transparent.

4. The photovoltaic device (**100, 200**) according to claim 1, wherein a refractive index of said barrier layer (**106, 206**) ranges between 1.4 and 2.2.

5. The photovoltaic device (**100, 200**) according to claim 1, wherein a thickness of said barrier layer (**106, 206**) ranges between 1 nanometer and 150 nanometers.

6. The photovoltaic device (**100, 200**) according to claim 1, wherein a material of said barrier layer (**106, 206**) is selected from the group comprising silicon oxides (SiOₓ), silicon nitrides (SiNₓ), Al₂O₃, ZnS:SiO₂ and SiON.

7. A photovoltaic device (**100, 200**) for photoelectric conversion of incident solar light, the photovoltaic device (**100, 200**) comprising a stack of at least a transparent substrate (**102, 202**) having a substantially flat surface; a textured layer (**104, 204**) provided on said substantially flat surface of said transparent substrate (**102, 202**) wherein said textured layer (**104, 204**) has light trapping structures; a transparent conductive oxide layer (**108, 208**) provided on said textured layer (**104, 204**); one or more semiconductor layers (**110, 112, 114, 210, 212, 214, 216, 218**) provided on said transparent conductive oxide layer (**108, 208**); and a cover substrate (**116**), **characterized in that**:
a barrier layer (**106, 206**) deposited on said textured layer (**104, 204**) prior to providing said transparent conductive oxide layer (**108, 208**), wherein said barrier layer (**106, 206**) is impermeable to one or more fluids released by said textured layer (**104, 204**), further wherein contamination of said one or more semiconductor layers (**110, 112, 114, 210, 212, 214, 216, 218**) from said one or more fluids is prevented by said barrier layer (**106, 206**).

8. The photovoltaic device (**100, 200**) according to claim 7, wherein said textured layer (**104,204**) is of a viscous curable material.

9. The photovoltaic device (**100, 200**) according to claim 7, wherein said barrier layer (**106, 206**) is optically transparent

10. The photovoltaic device (**100, 200**) according to claim 7, wherein a refractive index of said barrier layer (**106, 206**) ranges between 1.4 and 2.2.

11. The photovoltaic device (**100, 200**) according to claim 7, wherein a thickness of said barrier layer (**106, 206**) ranges between 1 nanometer and 150 nanometers.

12. The photovoltaic device (**100, 200**) according to claim 7, wherein a material of said barrier layer (**106, 206**) is selected from the group comprising silicon oxides (SiOₓ), silicon nitrides (SiNₓ), Al₂O₃, ZnS:SiO₂ and SiON.

13. The photovoltaic device (**100, 200**) according to claim 7, wherein said barrier layer (**106, 206**) facilitates adhesion between said textured layer (**104, 204**) and said transparent conductive oxide layer (**108, 208**).

14. The photovoltaic device according to claim 13, wherein adhesion between said barrier layer (**106, 206**) and said transparent conductive oxide layer (**108, 208**) is greater than adhesion between said layer (**104, 204**) of the viscous curable material and said transparent conductive oxide layer (**108, 208**).
